(19) Europäisches Patentamt
European Patent Office
Office européen des brevets

(11) **EP 3 528 384 B1**

(12) **FASCICULE DE BREVET EUROPEEN**

(45) Date de publication et mention
de la délivrance du brevet:
**22.09.2021 Bulletin 2021/38**

(51) Int Cl.:
**H02P 27/08** (2006.01)   **H02M 1/12** (2006.01)
**H02M 1/44** (2007.01)

(21) Numéro de dépôt: **19152553.4**

(22) Date de dépôt: **18.01.2019**

(54) **PROCÉDÉ DE COMMANDE D'UN CONVERTISSEUR CONNECTÉ À UNE MACHINE ÉLECTRIQUE**

STEUERUNGSVERFAHREN EINES SPANNUNGSWANDLERS, DER MIT EINER ELEKTRISCHEN MASCHINE VERBUNDEN IST

METHOD FOR CONTROLLING A CONVERTER CONNECTED TO AN ELECTRIC MACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.02.2018 FR 1851232**

(43) Date de publication de la demande:
**21.08.2019 Bulletin 2019/34**

(73) Titulaire: **Schneider Toshiba Inverter Europe SAS 27120 Pacy sur Eure (FR)**

(72) Inventeurs:
• **BOULHARTS, Hocine**
**78510 Triel sur Seine (FR)**
• **FEHRINGER, Rudolf**
**1230 Wien (AT)**

(74) Mandataire: **Mouney, Jérôme et al Schneider Electric Industries SAS Service Propriété Industrielle 35 rue Joseph Monier - CS30323 92506 Rueil Malmaison Cedex (FR)**

(56) Documents cités:
• JUHAMATTI KORHONEN ET AL: "Control of an inverter output active du/dt filtering method", IECON 2009 - 35TH ANNUAL CONFERENCE OF IEEE INDUSTRIAL ELECTRONICS (IECON 2009) - 3-5 NOV. 2009 - PORTO, PORTUGAL, IEEE, PISCATAWAY, NJ, USA, 3 novembre 2009 (2009-11-03), pages 316-321, XP031629591, ISBN: 978-1-4244-4648-3
• J-P STROM ET AL: "Active du/dt filtering for variable-speed AC drives", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8 septembre 2009 (2009-09-08), pages 1-10, XP031541801, ISBN: 978-1-4244-4432-8
• TYSTER J ET AL: "High-speed gate drive scheme for three-phase inverter with twenty nanosecond minimum gate drive pulse", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8 septembre 2009 (2009-09-08), pages 1-10, XP031541486, ISBN: 978-1-4244-4432-8

**Description**

**Domaine technique de l'invention**

La présente invention se rapporte à un procédé de commande d'un convertisseur connecté à une machine électrique. L'invention concerne également un système de commande adapté pour mettre en œuvre le procédé.

**Etat de la technique**

Un convertisseur de type DC/AC, appelé également onduleur est destiné à la commande d'une machine électrique. Il est connu que de fortes variations de tension (dv/dt) peuvent apparaître au moment de la commutation des transistors de l'onduleur, pouvant occasionner la génération de courants de fuite, de pertes dans l'onduleur et de surtensions dans le bobinage du stator de la machine électrique, notamment si la machine est connectée au convertisseur par un long câble.

Pour remédier à ces problèmes, une solution consiste à placer en sortie de l'onduleur un filtre de type dv/dt qui comporte plusieurs composants passifs, c'est-à-dire une inductance, un condensateur et une résistance d'amortissement. Cette solution nécessite cependant l'emploi d'une résistance qui dissipe de l'énergie.

Une autre solution consiste à utiliser un convertisseur à au moins trois niveaux de tension. Il s'agit alors de générer une première impulsion de tension jusqu'à mi-tension (E/2) et une autre impulsion d'amplitude E/2 pour atteindre la tension E. La deuxième impulsion est générée avec un retard de deux fois le temps de propagation du câble. Cependant, une telle séquence ne peut pas être mise en œuvre aisément à l'aide d'un convertisseur à deux niveaux.

Afin de contrôler les variations de tension (dv/dt) à chaque commutation dans un convertisseur à deux niveaux, il a été proposé dans la publication référencée ″Juhamatii Korhonen, Juha-Pekka Ström, Juho Tyser, Pertti Silventoinen, Hannu Sarén and Kimmo Rauma - « Control of an inverter output active du/dt filtering method » - in Proceedings of the 35th. Annual Conférence of the IEEE Industrial Electronics Society, IECON 2009″ de générer une séquence de plusieurs impulsions successives à chaque transition de commutation d'un interrupteur de puissance de l'onduleur. Cette solution permet de s'affranchir de l'utilisation de la résistance d'amortissement. Elle n'est cependant pas toujours satisfaisante pour obtenir la tension souhaitée à l'entrée du câble et donc la tension souhaitée à la sortie du câble, c'est-à-dire aux bornes de la machine électrique.

Le but de l'invention est donc de proposer un procédé d'optimisation de la commande appliquée à un convertisseur qui permette de limiter les surtensions aux bornes de la machine électrique.

La solution de l'invention pourra également être adaptée pour minimiser les pertes par commutation dans l'onduleur et/ou pour minimiser la variation de la tension à l'entrée du câble.

**Exposé de l'invention**

Ce but est atteint par un procédé de commande d'un convertisseur connecté à une machine électrique par un câble via un filtre connecté à la sortie de l'onduleur, ledit câble comprenant au moins deux conducteurs et présentant une impédance et ledit filtre étant de type LC et comprenant au moins une inductance et un condensateur pour chaque conducteur du câble, ledit convertisseur comprenant au moins deux bras de commutation comportant chacun au moins deux interrupteurs de puissance commutés pour découper une tension continue ayant une valeur E afin de fournir au moins deux niveaux de tension, la commande d'un bras de commutation permettant de générer des impulsions de tension sur la phase de sortie qui lui est connectée, une impulsion de tension pouvant être de type croissante et comporter un front de tension vertical montant avec un palier de durée non nulle à la valeur E ou de type décroissante avec un palier de durée non nulle à la valeur 0V et comporter un front de tension vertical descendant,
ledit procédé consistant à déterminer au moins une séquence de plusieurs impulsions de tension formant un signal carré à appliquer sur chaque conducteur à chaque transition de commutation des deux interrupteurs de puissance d'un même bras de commutation, les deux interrupteurs étant commandés en complémentaire, pour minimiser un niveau de surtension aux bornes de la machine électrique, ladite séquence comprenant un nombre 2N d'impulsions successives, N étant supérieur ou égal à 1, chaque impulsion étant défini par un rang n distinct, ladite séquence étant générée en remplaçant chaque front montant et chaque front descendant des impulsions de tension générées à la période de découpage de la tension continue et de sorte que chaque impulsion de tension croissante de rang n présente une largeur d'impulsion identique à celle d'une impulsion de tension décroissante de rang égal à 2N+1-n, et le procédé comporte les étapes suivantes :

- Déterminer le nombre d'impulsions successives de ladite séquence,
- Déterminer la largeur de chaque impulsion de la séquence adaptée pour minimiser le niveau de surtension aux bornes de la machine électrique (M) en respectant la relation suivante :

$$t_N = t_p + t_r/2$$

Dans laquelle :

- $t_N$ correspond à un instant temporel de fin de l'impulsion de rang N,
- $t_p$ correspond au temps de propagation du câble,
- $t_r$ correspond au temps de montée de la tension présente à l'entrée du câble pour atteindre 50% de ladite valeur E de la tension continue;

le procédé comportant une étape d'augmentation du nombre d'impulsions de la séquence tant que le niveau de surtension obtenu dépasse une valeur seuil.

Selon une particularité, le procédé comporte une étape de détermination du niveau de surtension à partir de la relation suivante :

$$Int_{Vo} = \lim_{T \to \infty} \frac{1}{T} \int_0^T \left( Vo\left(L, C, Zc, t_p, t_1, t_2, t_3 \cdots t_{2N}\right) \right)^2 dt$$

Dans laquelle :

- $Int_{Vo}$ correspond audit niveau de surtension résultant du calcul de l'intégrale de la tension *Vo* aux bornes de la machine électrique ;
- L correspond à la valeur de l'inductance du filtre ;
- C correspond à la capacité du condensateur du filtre ;
- Zc correspond à l'impédance caractéristique du câble.

Selon une autre particularité, le procédé comporte au moins une étape de comparaison du niveau de surtension déterminé pour ladite séquence d'impulsion avec une valeur seuil.

Selon une autre particularité, le procédé comporte une étape de détermination du temps de montée de la tension présente à l'entrée du câble pour atteindre 50% de ladite valeur E de la tension continue à partir de la relation suivante :

$$t_r = f(L, C, Zc, d_1, d_2 \ldots d_N)$$

Dans laquelle :

- L correspond à la valeur de l'inductance du filtre ;
- C correspond à la capacité du condensateur du filtre ;
- Zc correspond à l'impédance caractéristique du câble ;
- $d_1, d_2 \ldots d_N$ correspondent à la largeur de chaque impulsion de rang n de ladite séquence d'impulsions.

Selon une autre particularité, le procédé comporte une étape de saisie ou d'identification des paramètres suivants :

- L correspondant à la valeur de l'inductance du filtre ;
- C correspondant à la capacité du condensateur du filtre ;
- Zc correspondant à l'impédance caractéristique du câble ;
- tp correspondant au temps de propagation du câble.

L'invention concerne également un système de commande d'un convertisseur connecté à une machine électrique par un câble via un filtre, ledit câble comprenant au moins deux conducteurs et présentant une impédance et ledit filtre étant de type LC et comprenant au moins une inductance et un condensateur pour chaque conducteur du câble, ledit convertisseur comprenant au moins deux bras de commutation comportant chacun au moins deux interrupteurs de puissance commutés pour découper une tension continue ayant une valeur E afin de fournir au moins deux niveaux de tension, la commande d'un bras de commutation permettant de générer des impulsions de tension sur la phase de sortie qui lui est connectée, une impulsion de tension pouvant être de type croissante et comporter un front de tension vertical montant ou de type décroissante et comporter un front de tension vertical descendant, ledit système étant adapté pour déterminer au moins une séquence de plusieurs impulsions de tension formant un signal carré à appliquer sur chaque conducteur à chaque transition de commutation des deux interrupteurs de puissance d'un même bras de commutation pour minimiser un niveau de surtension aux bornes de la machine électrique (M), ladite séquence comprenant un nombre 2N d'impulsions successives, N étant supérieur ou égal à 1, chaque impulsion étant défini par un rang n distinct, ladite séquence étant générée de sorte que chaque impulsion de tension croissante de rang n présente une largeur d'impulsion identique à celle d'une impulsion de tension décroissante de rang égal à 2N+1-n, et le système est également adapté pour :

- Déterminer le nombre d'impulsions successives de ladite séquence,
- Déterminer la largeur de chaque impulsion de la séquence adaptée pour minimiser le niveau de surtension aux bornes de la machine électrique en respectant la relation suivante :

$$t_N = t_p + t_r/2$$

Dans laquelle :

- $t_N$ correspond à un instant temporel de fin de l'impulsion de rang N,
- $t_p$ correspond au temps de propagation du câble,
- $t_r$ correspond au temps de montée de la tension (Vi) présente à l'entrée du câble pour atteindre 50% de ladite valeur E de la tension continue.

Selon une particularité, le système est adapté pour déterminer un niveau de surtension à partir de la relation suivante :

$$Int_{Vo} = \lim_{T \to \infty} \frac{1}{T} \int_0^T \left( Vo\big(L, C, Zc, t_p, t_1, t_2, t_3 \cdots t_{2N}\big) \right)^2 dt$$

Dans laquelle :

- $Int_{Vo}$ correspond audit niveau de surtension résultant du calcul de l'intégrale de la tension *Vo* aux bornes de la machine électrique ;
- L correspond à la valeur de l'inductance du filtre ;
- C correspond à la capacité du condensateur du filtre ;
- Zc correspond à l'impédance caractéristique du câble.

Selon une autre particularité, le système est adapté pour comparer ledit niveau de surtension déterminé pour ladite séquence d'impulsion avec une valeur seuil.

Selon une autre particularité, le système est adapté pour augmenter le nombre d'impulsions de la séquence tant que le niveau de surtension obtenu dépasse ladite valeur seuil.

Selon une autre particularité, le système est adapté pour déterminer le temps de montée de la tension (Vi) présente à l'entrée du câble pour atteindre 50% de ladite valeur E de la tension continue à partir de la relation suivante :

$$t_r = f(L, C, Zc, d_1, d_2 \ldots d_N)$$

Dans laquelle :

- L correspond à la valeur de l'inductance du filtre ;
- C correspond à la capacité du condensateur du filtre ;
- Zc correspond à l'impédance caractéristique du câble ;
- $d_1, d_2 \ldots d_N$ correspondent à la largeur de chaque impulsion de rang n de ladite séquence d'impulsions.

Selon une autre particularité, le système comporte un module de saisie ou d'identification des paramètres suivants :

- L correspondant à la valeur de l'inductance du filtre ;
- C correspondant à la capacité du condensateur du filtre ;
- Zc correspondant à l'impédance caractéristique du câble ;
- tp correspondant au temps de propagation du câble.

La solution décrite dans la publication antérieure citée ci-dessus met en œuvre des impulsions qui sont toujours d'une même largeur. Pour cela, elle s'appuie sur les caractéristiques du filtre (la valeur de l'inductance et celle de la capacité du condensateur). Comme le câble est connecté en parallèle sur le condensateur du filtre résonant, l'impédance d'entrée du câble (Zi) est en parallèle avec le condensateur du filtre.

Dans cette situation, une première solution est de choisir un condensateur qui dispose d'une très grande capacité, permettant d'imposer une impédance faible par rapport à l'impédance du câble et ainsi de négliger l'impédance du câble. Ceci facilite la détermination des largeurs des impulsions pour un motif choisi (nombre d'impulsions et type d'impulsion) à la seule connaissance des valeurs de l'inductance et de capacité du condensateur. La variation de tension (dv/dt) générée est fixée à quatre fois la valeur du temps de propagation ($t_p$) du câble afin de limiter la surtension en bout du câble et donc aux bornes de la machine électrique. Cette solution a cependant certaines limites :

1) Au-delà d'une longueur de câble, son impédance d'entrée Zi devient non négligeable, (Zi étant une impédance dépendant du temps de propagation $t_p$);
2) La valeur de la capacité du condensateur du filtre devient très grande, impliquant un courant de pic très grand, supérieur à ce que peut occasionner un câble seul. Les pertes dans les interrupteurs de puissance du convertisseur deviennent très importantes.

Une autre approche consiste à tenir compte des éléments du câble ($t_p$, Zc) (Zc étant l'impédance caractéristique du câble équivalente à une résistance) et du filtre résonant LC. La valeur de la capacité du condensateur du filtre résonant peut être choisi indépendamment du câble. L'impédance du condensateur du filtre peut être supérieure à l'impédance d'entrée Zi du câble connecté sur le filtre. Le courant pic est réduit et par conséquent les pertes générées dans les composants de puissance du convertisseur diminuent par rapport aux solutions présentées précédemment. Cependant, cette liberté qui est offerte sur le choix de la valeur de capacité du condensateur est possible à condition d'appliquer une séquence particulière optimisée des impulsions. Et il s'agit de la séquence optimale qui est générée par le procédé de l'invention.

**Brève description des figures**

D'autres caractéristiques et avantages vont apparaître dans la description détaillée qui suit faite en regard des dessins annexés dans lesquels :

- La figure 1 représente une installation comprenant un convertisseur de type onduleur connecté à une machine électrique, telle qu'un moteur électrique ;
- La figure 2A représente de manière simplifiée, une seule phase du convertisseur connectée à la machine électrique et la figure 2B représente un schéma équivalent ;
- La figure 3 représente de manière schématique plusieurs diagrammes illustrant le principe de l'invention ;
- La figure 4 représente de manière schématique un diagramme montrant une séquence d'impulsions optimale conforme à celle générée dans l'invention ;
- Les figures 5A à 5C représentent de manière schématique plusieurs diagrammes illustrant le principe de l'invention ;
- La figure 6 représente une simulation de fonctionnement du principe de l'invention ;
- La figure 7 illustre un exemple d'algorithme exécuté pour déterminer la séquence d'impulsions optimale.

**Description détaillée d'au moins un mode de réalisation**

L'invention s'applique à une installation de commande comprenant notamment un convertisseur connecté à une machine électrique. De manière non limitative, la machine électrique peut être un moteur électrique.

Le convertisseur est de type DC/AC, c'est-à-dire qu'il s'agit d'un onduleur.

Cet onduleur 200 peut être intégré à un variateur de vitesse.

L'onduleur 200 reçoit en entrée une tension continue E. De manière non limitative, la tension continue est fournie par un bus continu connecté à un étage redresseur situé en entrée et destiné à convertir une tension alternative fournie par le réseau électrique en une tension continue. Le bus continu comporte deux lignes d'alimentation et des condensateurs de bus Cb1, Cb2 connectés entre les deux lignes d'alimentation pour stabiliser la tension continue.

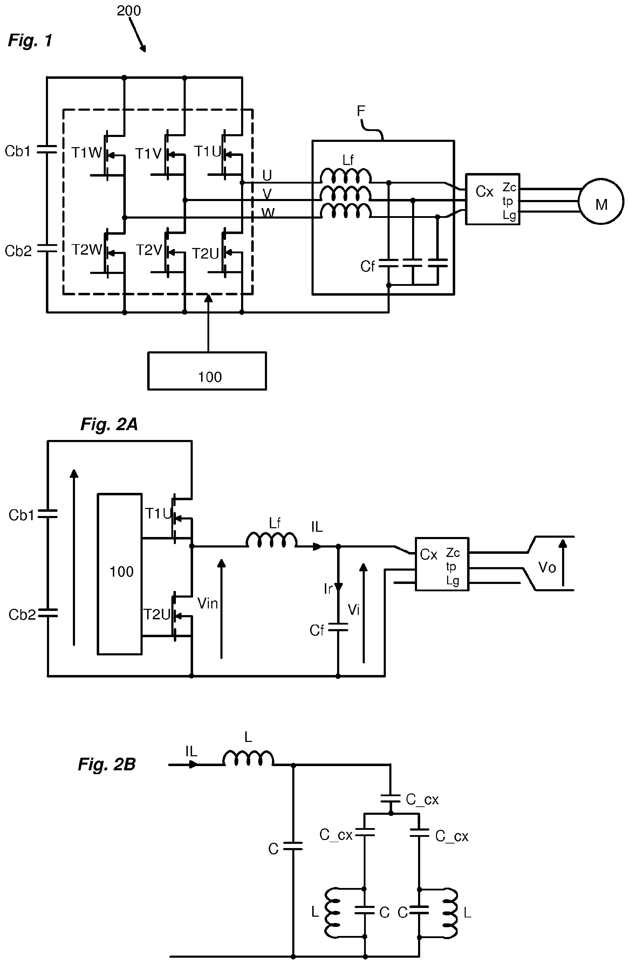

L'onduleur 200 peut présenter deux ou trois phases de sortie U, V, W sur lesquelles vient se connecter la machine électrique. Sur la figure 1, l'onduleur 200 est représenté avec trois phases de sortie.

L'onduleur 200 comporte plusieurs bras de commutation connectés en parallèle entre les deux lignes d'alimentation du bus.

L'onduleur 200 peut être à deux niveaux de tension ou à plus de deux niveaux de tension.

Dans un onduleur à deux niveaux de tension, chaque bras de commutation comporte deux interrupteurs de puissance T1U, T2U, T1V, T2V, T1W, T2W. Une phase de sortie distincte est connectée au point milieu situé entre les deux interrupteurs.

A deux niveaux de tension, chaque bras de commutation peut fournir une tension égale à 0 ou une tension égale à E.

De manière non limitative, les interrupteurs de puissance peuvent être des transistors de type IGBT, MOSFET, JFET.

Les phases de sortie de l'onduleur 200 sont connectées chacune à un conducteur distinct d'un câble Cx destiné à relier la sortie de l'onduleur à la machine électrique M. Ce câble Cx peut notamment présenter une longueur Lg de plusieurs mètres. Il comporte des caractéristiques particulières, notamment une longueur Lg, une impédance caractéristique Zc et un temps de propagation $t_p$.

Pour rappel, dans un câble on définit une impédance d'entrée Zi qui caractérise la signature fréquentielle du câble et l'impédance caractéristique Zc du câble, qui est indépendante de la longueur de ce dernier. Elle est définie par l'expression suivante :

$$Zc = \sqrt{\frac{Lc}{Cc}}$$

Dans laquelle Lc est l'inductance du câble pour une longueur donnée et Cc est la capacité du câble entre 2 phases pour la même longueur donnée.

Pour un temps inférieur à 2*tp (temps de propagation du câble) l'impédance Zi est proche de l'impédance Zc.

L'installation de commande comporte un filtre F connecté à la sortie de l'onduleur 200. Ce filtre est de type LC et ne comporte avantageusement aucune résistance d'amortissement. Pour chaque phase de sortie, le filtre comporte une inductance Lf (de valeur L) connectée en série sur la phase de sortie et un condensateur Cf (de capacité C) connecté d'une part à l'inductance et d'autre part à une ligne d'alimentation du bus.

L'installation de commande comporte également un système de commande 100 destiné à générer les ordres de commande à appliquer aux interrupteurs de puissance de l'onduleur 200 et à émettre lesdits ordres de commande à destination des unités de pilotage des interrupteurs de puissance. Le système de commande 100 comporte au moins un microprocesseur et des moyens de mémorisation.

De manière classique, le système de commande 100 est destiné à générer des ordres de commande à destination des interrupteurs de puissance des bras de commutation.

Pour simplifier, la figure 2A représente une installation à une seule phase connectée à la machine électrique M.

Sur chaque bras de commutation, les deux interrupteurs sont commandés en complémentaire, c'est-à-dire que lorsque l'un d'eux est à l'état fermé, l'autre est à l'état ouvert et inversement.

Lors de la commande appliquée sur un bras de commutation à deux niveaux, la tension continue est découpée entre deux niveaux de tension. Un premier niveau de tension est égal à 0V et un deuxième niveau de tension est égal à la tension continue égale à E.

La commande d'un bras de commutation permet de générer des impulsions de tension sur la phase de sortie qui lui est connectée. Une impulsion de tension peut être :

- De type croissante et comporter un front de tension vertical montant entre la valeur 0V et la valeur E suivi d'un palier de durée non nulle à la valeur E ;

- De type décroissante et comporter un front de tension vertical descendant entre la valeur E et la valeur 0V suivi d'un palier de durée non nulle à la valeur 0V.

Chaque impulsion est définie par un instant de début et par un instant de fin, la durée séparant l'instant de début et l'instant de fin formant la largeur (d) de l'impulsion. On verra ci-après que cette largeur peut être variable d'une impulsion à l'autre.

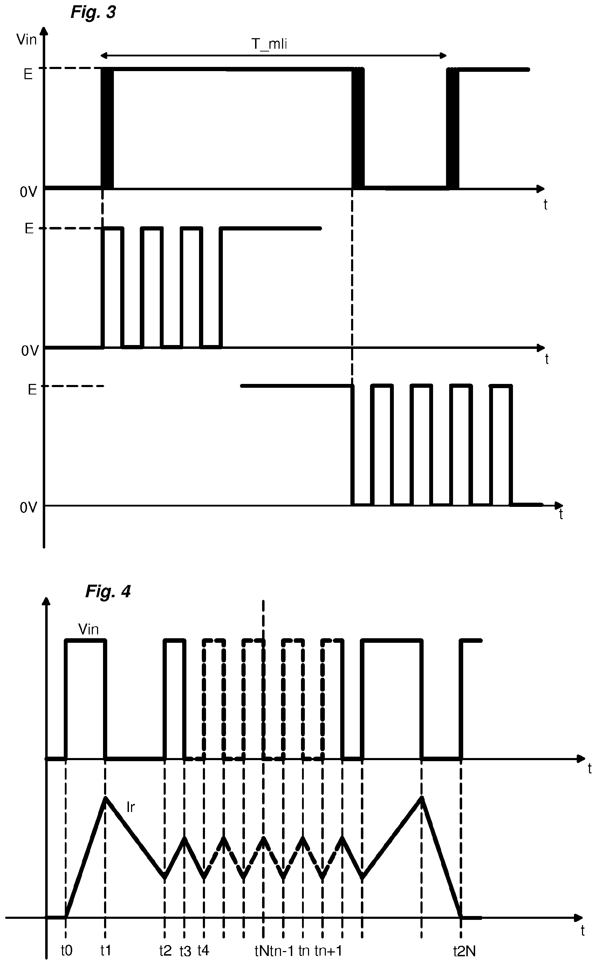

De manière classique, les ordres de commande des interrupteurs d'un onduleur 200 sont générés par modulation de largeur d'impulsion (ci-après MLI). Les ordres de commande appliqués aux deux interrupteurs d'un même bras de commutation permettent de générer des impulsions de tension en sortie à une période de découpage T_mli (figure 3).

En référence à la figure 2A, on définit les grandeurs suivantes :

- E correspond à la tension continue fournie en entrée de l'onduleur 200 ;

- Vin correspond à la tension fournie sur chaque phase de sortie de l'onduleur 200. Cette tension se compose d'impulsions de tension successives obtenues par commutation complémentaire des deux interrupteurs de puissance du bras de commutation considéré.

- Vi correspond à la tension en entrée du câble, en aval du filtre et donc aux bornes du condensateur Cf du filtre.

- Vo correspond à la tension en sortie du câble, c'est-à-dire aux bornes de la machine électrique M connectée au câble Cx. Entre l'entrée et la sortie du câble, le câble peut notamment présenter une certaine longueur venant influencer le fonctionnement de l'installation.

- Ir correspond au courant de résonance traversant le condensateur Cf du filtre F.

- IL correspond au courant traversant l'inductance Lf du filtre F.

A l'aide d'un onduleur à plus de deux niveaux, il est connu que l'on peut réduire considérablement les surtensions aux bornes de la machine électrique. Une première impulsion est générée à mi tension (E/2) suivie d'une autre impulsion d'amplitude E/2 superposée à la première impulsion (E/2 $\rightarrow$ E) avec un retard de deux fois le temps de propagation $t_p$ du câble. Cette forme d'onde est générée facilement à l'aide d'un onduleur à 3 niveaux de tension (0, E/2 et E).

Le principe de l'invention réside notamment à proposer une séquence d'impulsions permettant de s'approcher de cette forme d'onde de la tension Vi afin de limiter les oscillations de surtension à l'extrémité du câble Cx connecté à la machine électrique. La solution de l'invention pourra s'appliquer quel que soit le nombre de niveaux de l'onduleur mais on comprend aisément qu'elle présente un intérêt particulier pour un onduleur qui ne peut générer que deux niveaux de tension.

Afin d'obtenir une variation de la tension Vi qui suit un profil 0, E/2 et E, on va s'appuyer sur une séquence d'impulsions successives caractérisée par la relation suivante :

$$t_N = t_p + t_r/2$$

Avec $t_N$ qui est l'instant définissant un axe de symétrie de la séquence (voir ci-dessous), $t_p$ le temps de propagation du câble (caractéristique connue) et $t_r$ la durée de montée de la tension Vi à la mi-tension (E/2).

Selon un aspect de l'invention, il s'agit d'optimiser la commande appliquée à l'onduleur 200 en vue de remplir un ou plusieurs des objectifs suivants :

- Minimiser les surtensions et oscillations de tension aux bornes de la machine électrique ;

- Minimiser les pertes dans le convertisseur, c'est-à-dire agir sur l'amplitude du courant résonant Ir à chaque commutation d'un interrupteur de puissance ;

- Minimiser la variation (le dv/dt) de la tension Vi en entrée du câble.

En référence à la figure 3, le principe de l'invention consiste notamment à générer une séquence de plusieurs impulsions successives à chaque transition de commutation des deux interrupteurs de puissance d'un même bras de commutation. A l'ouverture et à la fermeture des interrupteurs de puissance du bras de commutation, une séquence de plusieurs impulsions successives est générée, remplaçant chaque front montant et chaque front descendant des impulsions de tension générées à la période de découpage T_mli. Par transition de commutation, on entend que l'un des deux interrupteurs du bras de commutation passe de l'état ouvert à l'état fermé et que l'autre des deux interrupteurs du bras de commutation passe de l'état fermé à l'état ouvert (commande en complémentaire). Le principe s'appliquera de manière identique pour un onduleur à plus de deux niveaux.

Chaque séquence d'impulsions se présente sous la forme d'un signal carré comportant plusieurs impulsions successives, c'est-à-dire qu'une impulsion croissante est suivie d'une impulsion décroissante.

Selon un aspect particulier de l'invention, le système de commande vise à déterminer la séquence d'impulsions optimale à appliquer à chaque transition de commutation des interrupteurs de puissance d'un bras de commutation, lors du découpage de la tension à la période de découpage T_mli.

Une séquence d'impulsions optimale déterminée par le système comporte un nombre optimal d'impulsions successives et chaque impulsion y est caractérisée par une largeur déterminée également optimale par rapport à l'objectif ciblé.

La séquence d'impulsions optimale permet de limiter les surtensions et les oscillations de la tension Vo aux bornes de la machine électrique lors de la transition.

En référence à la figure 4, la séquence d'impulsions optimale comporte ainsi les caractéristiques générales suivantes :

- Elle comporte un nombre 2N d'impulsions successives ;
- Une impulsion de type croissante est suivie d'une impulsion de type décroissante et inversement ;
- Les impulsions sont définies chacune par un rang n, n allant de 1 à 2N ;
- Chaque impulsion de rang n présente un instant de début défini par $t_{n-1}$ et un instant de fin défini par $t_n$; L'impulsion de rang 1 présente donc un instant de début défini par $t_0$ et un instant de fin défini par $t_1$;
- Chaque impulsion de rang n présente une largeur d'impulsion référencée $d_n$; la largeur d'impulsion $d_n$ d'une impulsion correspond à la durée s'écoulant entre l'instant $t_{n-1}$ et l'instant $t_n$;
- La largeur d'une impulsion de rang n est définie par les relations suivantes :

$$d_n = \frac{\theta_n}{2\pi \cdot Fres} \qquad (1)$$

Avec :

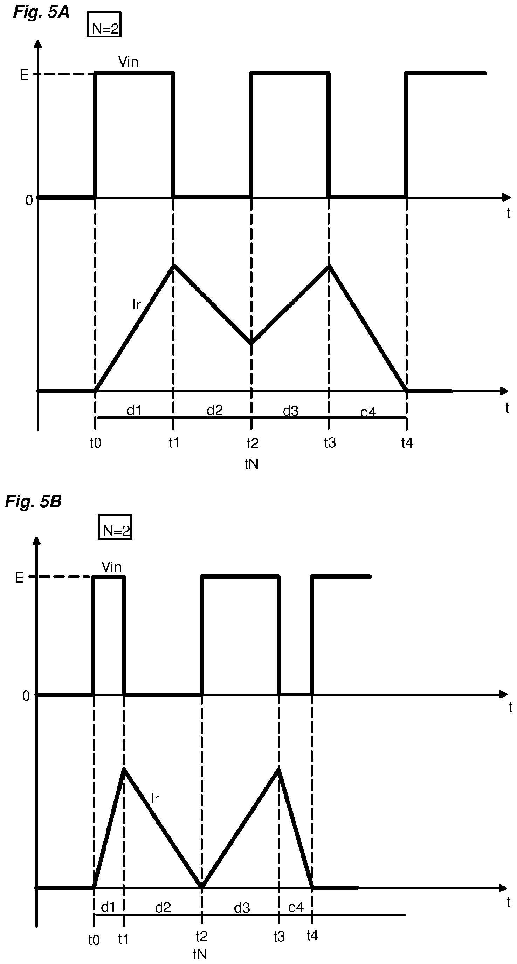

- $\theta_n$ qui définit l'angle de conduction de rang n. La valeur de cet angle dépend du nombre d'impulsions de la séquence et de la séquence d'impulsions appliquée. Par exemple pour la séquence définie par la Figure 5B et N égale à 2, les angles de conduction sont égaux à :

$$\theta_1 = 0.506rd, \ \theta_2 = 1.318rd, \ \theta_3 = 1.318rd, \ \theta_4 = 0.506rd$$

et pour la séquence définie par le figure 5A et N égale à 2, les angles de conduction seront égaux entre eux.

$$\theta_1 = \theta_2 = \theta_3 = \theta_4 = \frac{\pi}{7}rd$$

- *Fres* qui correspond à la première fréquence de résonance du filtre associé à l'impédance Zi du câble selon la Figure 2B.

La fréquence Fres est la fréquence de résonnance du filtre LC associé au câble. Une première approche est de déterminer Fres par le schéma équivalent de la figure 2B. Ce schéma équivalent représente la configuration d'une commutation d'une phase, les deux autres phases du convertisseur étant reliées au moyen du bus. Les trois condensateurs repérés par la référence C_cx représentent la capacité totale du câble entre chaque phase, les inductances équivalentes du filtre prennent chacune la valeur L et les capacités équivalentes du filtre prennent la valeur C.

La détermination des instants $t_1$ et $t_2...t_n$ est relative aux largeurs des impulsions et se déduit de la relation ci-dessous. L'instant $t_0$ est le début de la séquence.

-

$$t_n = t_{n-1} + d_n \qquad (2)$$

- Les largeurs des impulsions sont toutes déterminées de manière indépendante ;

- L'instant $t_N$ correspond à l'instant médian de la séquence ;

- Dans une même séquence, à chaque impulsion (croissante ou décroissante) de rang n correspond une impulsion symétrique en amplitude et en durée (respectivement décroissante ou croissante) définie par un rang égal 2N+1-n ; L'instant $t_N$ forme ainsi un axe de symétrie entre les impulsions situées en amont et les impulsions situées en aval ;

- La séquence comporte autant d'impulsions croissantes que d'impulsions décroissantes.

Pour déterminer la séquence d'impulsions optimale, le système de commande 100 applique un algorithme permettant de déterminer à la fois le nombre d'impulsions de la séquence et la largeur de chaque impulsion.

L'algorithme exécuté par le système 100 s'appuie notamment sur un objectif à remplir.

De manière non limitative, l'objectif ciblé peut être choisi parmi :

- Minimiser les surtensions et les oscillations aux bornes de la machine électrique, pouvant s'exprimer par la relation suivante :

$$Int_{Vo} = \lim_{T \to \infty} \frac{1}{T} \int_0^T \left( Vo\left(L, C, Zc, t_p, t_1, t_2, t_3 \cdots t_{2N}\right)\right)^2 dt \to min \qquad (3)$$

Dans laquelle :

- $Int_{Vo}$ correspond à l'intégrale de la tension $Vo$ aux bornes de la machine électrique ;

- Minimiser les pertes dans le convertisseur, c'est-à-dire agir sur l'amplitude du courant résonant (Ir) à chaque commutation du transistor (Irsw). Cet objectif peut s'exprimer par la relation suivante :

$$Int_{IrSW} = (E \cdot Fsw \cdot Esw) \cdot \sum_0^N \left( Irsw\left(E, L, C, Zc, t_p, t_0, t_1, t_2, t_3 \ldots t_{2N}\right)\right) \to min \qquad (4)$$

Dans laquelle :

- $Int_{IrSW}$ correspond à l'intégrale des pertes par commutation générées à chaque commutation d'un interrupteur.

- Minimiser le courant de terre, c'est-à-dire minimiser le dv/dt de la tension Vi.

Cet objectif peut s'exprimer par la relation suivante :

$$Int_{dv/dt} = \sum_0^N \frac{dVi}{dt} \left((E, L, C, Zc, t_1, t_2, t_3 \ldots t_{2N})\right) \to min \qquad (5)$$

Dans laquelle :

- $Int_{dv/dt}$ correspond à l'intégrale de la variation de la tension Vi en entrée du câble.

Avantageusement, l'objectif poursuivi consiste à minimiser les surtensions et les oscillations aux bornes de la machine électrique. Cet objectif sera défini par une valeur seuil, référencée T_OverV au-dessous de laquelle le niveau de surtension devra se situer pour que la séquence soit considérée comme valide.

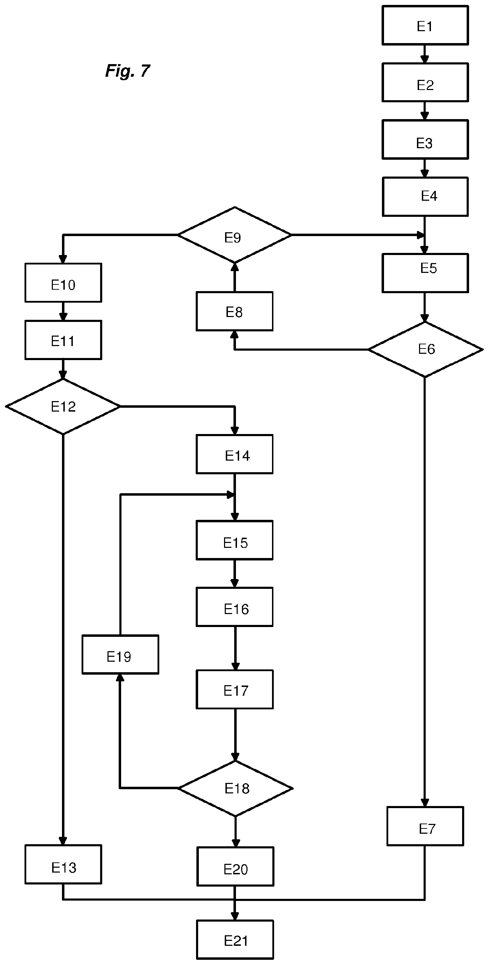

De manière non limitative, l'algorithme exécuté est par exemple schématisé sur la figure 7. Celui-ci est décrit ci-dessous en prenant par exemple comme objectif principal la diminution des surtensions aux bornes de la machine électrique lors de l'application d'une séquence de plusieurs impulsions successives lors de chaque transition de commutation au niveau d'un bras de commutation de l'onduleur. L'objectif visé est ainsi défini par la relation (3) déjà défini ci-dessus :

$$Int_{Vo} = \lim_{T \to \infty} \frac{1}{T} \int_0^T \left( Vo\left(L, C, Zc, t_p, t_1, t_2, t_3 \cdots t_{2N}\right)\right)^2 dt \to min$$

Dans laquelle :

- $Int_{Vo}$ correspond à l'intégrale de la tension $Vo$ aux bornes de la machine électrique ;

Cette expression définit un niveau de surtension référencé OverV de sorte que :

$$OverV = Int_{Vo} \qquad (6)$$

Il faut noter que l'algorithme présenterait une structure équivalente si l'objectif ciblé était différent et choisi parmi l'un des deux autres objectifs définis ci-dessus.

Pour exécuter l'algorithme, le système de commande comporte au moins une unité de commande comprenant un microprocesseur et des moyens de mémorisation.

Selon un aspect particulier de l'invention, la relation (3) ci-dessus est employée pour déterminer les instants de commutation $t_1$, $t_2$, $t_3 \cdots t_{2N}$ de la séquence.

De manière plus précise, la détermination des instants de commutation est effectuée en résolvant la contrainte établie par l'équation (3). Pour cela on applique le raisonnement ci-dessous en partant notamment de la fonction de transfert du câble entre la tension Vi et la tension Vo. Le câble est modélisable par le paramètre Zi(stp) qui est l'impédance d'entrée du câble et par T2(stp) qui est la fonction de transfert du câble, tous deux exprimées en transformée de Laplace.

$$Zi(stp) = \frac{Zc}{tanh(stp)}$$

$$T2(stp) = \frac{2e^{-stp}}{1+e^{-2stp}}$$

Définition de la fonction de transfert f(s) de Laplace d'une fonction f(t) :

$$f(s) = \int_0^\infty e^{-st} \cdot f(t)dt$$

Dans laquelle s est l'opérateur de la transformée de Laplace et t est le temps.

On déduit l'évolution de Vo en fonction de la tension d'entrée Vin dans le domaine de Laplace :

$$Vo(s) = Vin(s) \cdot \frac{1}{\cosh(stp)\left(s^2LC + sL\frac{\tanh(stp)}{Zc} + 1\right)}$$

On décompose la tension Vin en 2N échelon de tension (stepn) d'amplitude 1 et - 1, le signe de l'amplitude étant indexé par le rang n, instant de commutation.

$$Vin(t) = E \cdot \sum_{n=0}^{n=2N} step(t - t_n) \cdot (-1)^n$$

Afin de satisfaire le minimum d'ondulation de surtension, on minimise la valeur $Int_{Vo}$ définie par l'équation (3).

$$Int_{Vo} = \lim_{T \to \infty} \frac{1}{T} \int_0^T \left(Vo(L, C, Zc, t_p, t_1, t_2, t_3 \cdots t_{2N})\right)^2 dt \to min$$

$$Int_{Vo} = \lim_{T \to \infty} \frac{1}{T} E \int_0^T \left[\sum_{n=0}^{n=2N} step(t - t_n) \cdot (-1)^n \cdot h(t - t_n)\right]^2 dt$$

Le terme h(t) est la fonction inverse de la transformée de Laplace de G(s).

$$h(t) = \frac{1}{2\pi j} \int_{a-j\infty}^{a+j\infty} e^{st} \cdot G(s)ds$$

G(s) est définie par l'équation ci-dessous qui est la fonction de transfert observée par la sortie de l'onduleur.

$$G(s) = \frac{1}{\cosh(stp)\left(s^2LC + sL\frac{\tanh(stp)}{Zc} + 1\right)}$$

Une condition nécessaire pour minimiser $Int_{Vo}$ et donc les oscillations de tension est de satisfaire le système d'équation à 2N variables.

$$\frac{\partial Int_{Vo}}{\partial tn} = 0, \quad n \in 1 \text{ à } 2N$$

$$\frac{\partial Int_{Vo}}{\partial tn} = \frac{\partial}{\partial tn}\left[\lim_{T\to\infty}\frac{1}{T}E\int_0^T [\textstyle\sum_{n=0}^{n=2N} step(t - t_n)\cdot(-1)^n \cdot h(t - t_n)]^2 dt\right] = 0$$

Pour N=3, on aura ainsi :
Par la symétrie des impulsions, les instants $t_n$ sont reliés entre eux par les relations suivantes :

$$t_3 = t_N, \qquad t_6 = 2t_N, \ t_5 = 2t_N - t_1, \ t_4 = 2t_N - t_2$$

On peut ramener le système à 3 équations par ces relations ci-dessus.

$$\frac{\partial Int_{Vo}}{\partial t_1} = 0, \ \frac{\partial Int_{Vo}}{\partial t_2} = 0, \qquad \frac{\partial Int_{Vo}}{\partial t_3} = 0$$

On détermine $t_1$, $t_2$, $t_3 \cdots t_{2N}$ à l'aide du système d'équation ci-dessus (ici avec N=3).
De manière non limitative, en référence à la figure 7, l'algorithme exécuté par le système de commande comporte les étapes suivantes :

**Etape E1**

Cette première étape consiste à identifier les caractéristiques de l'installation. Ces caractéristiques sont notamment :

- Le temps de propagation $t_p$ du câble reliant l'onduleur à la machine ;

- L'impédance caractéristique Zc du câble ;

- La valeur L de l'inductance Lf du filtre ;

- La valeur de la capacité C du condensateur Cf du filtre ;

- La tension continue E fournie en entrée de l'onduleur 200.

A titre d'exemple, l'identification peut être mise en œuvre par saisie des différents paramètres ou reconnaissance automatique, par exemple lors d'une étape d'apprentissage mise en œuvre lors de la mise sous tension de l'installation.

**Etape E2**

Il s'agit d'enregistrer une valeur seuil de surtension T_OverV acceptable pour la machine électrique M. A titre d'exemple, cette valeur seuil T_OverV peut être saisie à l'aide d'une interface adaptée.

**Etape E3**

Cette étape marque le début de la détermination de la séquence d'impulsions. Pour cela, l'algorithme démarre de manière arbitraire avec un nombre d'impulsions défini par N=2 (c'est-à-dire 2N impulsions au total) et la séquence définie à la figure 5B, minimisant les pertes par commutation. Il serait possible de démarrer la séquence par un nombre d'impulsions différent. Dans tous les cas, l'algorithme permet de converger vers la séquence qui comporte un nombre N optimal par rapport à l'objectif visé.

**Etape E4**

A cette étape, le système détermine ainsi l'instant $t_1$ correspondant à l'instant de fin de la première impulsion (n=1) et l'instant $t_2$ correspondant à l'instant de fin de la deuxième impulsion (n=2).

On calcule la largeur $d_n$ d'une impulsion à partir de l'équation (1) reproduite ci-dessous :

$$d_n = \frac{\theta_n}{2\pi \cdot Fres} \qquad (1)$$

Avec $\theta_1$ = 0.506rd, $\theta_2$ = 1.318rd, $\theta_3$ = 1.318rd, $\theta_4$ = 0.506rd, relative à la figure 5B.

La détermination des instants $t_1$ et $t_2...t_n$ est relative aux largeurs des impulsions et se déduit de la relation (2) reproduite ci-dessous. L'instant $t_0$ est le début de la séquence.

$$t_n = t_{n-1} + d_n \qquad (2)$$

Les impulsions de rang 3 et 4 sont symétriques en amplitude et en durée par rapport aux impulsions respectivement de rang 2 et de rang 1 (selon la relation (7) suivante : $d_n = d_{2N+1-n}$)

**Etape E5**

A partir des données précédentes, il s'agit alors de déterminer de manière théorique le niveau de surtension OverV qui serait généré par la séquence d'impulsion établie précédemment. Le niveau de surtension OverV est donné par la relation (6) ci-dessus.

**Etape E6**

Il s'agit d'une étape de comparaison afin de déterminer si la valeur de surtension OverV déterminée à l'étape E5 est inférieure ou égale à une valeur seuil T_OverV qui est pré-mémorisée dans le système.

**Etape E7**

Si la valeur de surtension OverV est inférieure ou égale à la valeur seuil T_OverV alors la séquence d'impulsions est considérée comme valable et la séquence peut être finalisée en déterminant la largeur de chaque impulsion, notamment celles des impulsions symétriques en utilisant la relation ci-dessous :

$$d_n = d_{2N+1-n}$$

**Etape E8**

Si la valeur de surtension OverV est supérieure à la valeur seuil T_OverV alors on agit sur la largeur des impulsions. De manière arbitraire, on augmente la largeur de l'impulsion de rang 1 et on diminue la largeur de l'impulsion de rang 2. L'instant $t_1$ est déplacé d'une valeur déterminée (par exemple égale à $t_p/100$) pour augmenter la largeur de l'impulsion de rang 1 et l'instant $t_2$ est déplacé de la même valeur ($t_p/100$) pour diminuer la largeur de l'impulsion de rang 2.

**Etape E9**

Il s'agit d'une étape de test pour déterminer si les deux impulsions de rang 1 et de rang 2 pourraient être réunies en une seule impulsion. Pour cela, le test consiste à déterminer si $t_2 = t_1$.

Si l'instant $t_2$ n'est pas confondu avec $t_1$, on revient à l'étape E5 définie ci-dessus afin d'optimiser la largeur des impulsions pour N=2 jusqu'à atteindre un niveau de surtension acceptable.

**Etape E10**

Suite à l'étape E9, si l'instant $t_2$ se trouve être confondu avec l'instant $t_1$, le système examine la situation pour N=1.

**Etape E11**

Il s'agit de déterminer le niveau de surtension OverV qui pourrait survenir pour N=1, l'impulsion de rang 1 ayant une largeur définie par l'instant $t_1$ déterminé précédemment.

**Etape E12**

Il s'agit d'un nouveau test effectué sur le niveau de surtension OverV calculé lors de l'étape précédente par rapport à la valeur seuil pré-mémorisée T_OverV.

**Etape E13**

Si le niveau de surtension OverV est inférieur ou égal à la valeur seuil T_OverV, la séquence d'impulsions avec N=1 est validée, avec l'impulsion de rang 1 définie par l'instant $t_1$.

**Etape E14**

Si le niveau de surtension OverV est supérieur à la valeur seuil T_OverV, alors le système conclut qu'il faut augmenter le nombre d'impulsions dans la séquence.
Le système fixe donc le nombre N à 3.

**Etape E15**

Le système exécute une boucle afin de déterminer le nombre adapté d'impulsions. La boucle consiste tout d'abord à déterminer les instant $t_1$, $t_2$ jusqu'à $t_N$, et donc une séquence d'impulsions, permettant de remplir l'objectif déterminé.
De manière non limitative, l'objectif ciblé est de :

- Minimiser les surtensions et les oscillations aux bornes du moteur, pouvant s'exprimer par la relation (3) suivante

$$Int_{Vo} = \lim_{T \to \infty} \frac{1}{T} \int_0^T \left( Vo\left(L, C, Zc, t_p, t_1, t_2, t_3 \cdots t_{2N}\right) \right)^2 dt \to min$$

Dans laquelle :

- $Int_{Vo}$ correspond à l'intégrale de la tension $Vo$ aux bornes de la machine électrique.

Le système détermine chaque instant $t_n$ d'une séquence d'impulsion (c'est-à-dire les instants $t_1$, $t_2$, $t_3$ (égal à $t_N$ lorsque N=3)) permettant de remplir l'objectif visé, c'est-à-dire l'obtention d'un niveau de surtension minimal.

**Etape E16**

Le système détermine ensuite la durée $t_r$. Cette durée tr correspond au temps que met la tension Vi à l'entrée du câble à atteindre la valeur E/2. Dans le cas d'un convertisseur triphasé, la tension Vi correspond à la tension composée entre deux phases. Cette durée $t_r$ est fonction des éléments du filtre LC et de l'impédance caractéristique Zc du câble, ainsi que des largeurs des impulsions $d_1$ jusqu'à $d_N$ déterminées à partir des instants calculés lors de l'étape E17 précédente. On a ainsi :

$$t_r = f(L, C, Zc, d_1, d_2 \ldots d_N) \quad (8)$$

Dans laquelle :

$$d_n = t_n - t_{n-1}$$

Il faut noter que les données calculées pour la séquence doivent dans tous les cas vérifier les deux relations suivantes :

$$t_N = t_p + t_r/2 \qquad (9)$$

Et

$$t_r < 2t_p \qquad (10)$$

La séquence définie par un nombre N d'impulsions croissantes et N impulsions décroissantes est optimisée si cette équation (9) est satisfaite, c'est-à-dire si la tension Vo est proche de E/2 à l'instant $t_N$.

En définissant $t_N$, on définit la durée de la séquence ($2*t_N$). A titre optionnel, il est également possible de déterminer la pente de variation de la tension Vi (dv/dt) en fonction du temps par la relation suivante :

$$\frac{dv}{dt} = \frac{E}{2 \cdot t_r}$$

**Etape E17**

Il s'agit de déterminer le niveau de surtension OverV qui pourrait survenir pour la séquence d'impulsions définie par N (N au moins égal à 3 lors de la première boucle).

**Etape E18**

Une fois la séquence construite, il s'agit de vérifier si le niveau de surtensions généré est satisfaisant. Cette étape consiste donc à vérifier si le niveau de surtension obtenu grâce à cette séquence est inférieur ou égal à la valeur seuil T_OverV.

**Etape E19**

Si le niveau de surtensions OverV obtenu reste supérieur à la valeur seuil T_OverV, une nouvelle séquence doit être calculée. Cette nouvelle séquence sera générée en incrémentant la valeur de N d'une unité (N=N+1). Tant que la condition sur le niveau de surtensions obtenu n'est pas satisfaite, une nouvelle séquence sera calculée en augmentant à chaque boucle d'une unité le nombre d'impulsions défini par N.

**Etape E20**

Si le niveau de surtensions OverV déterminé à partir de la dernière séquence qui a été générée est inférieur ou égal à la valeur seuil T_OverV, le système peut finaliser la séquence en déterminant la largeur $d_n$ de chaque impulsion de la séquence en employant la relation suivante :

$$d_n = t_n - t_{n-1}$$

Et en tenant compte de la relation suivante pour assurer la symétrie par rapport à l'instant $t_N$:

$$d_n = d_{2N+1-n}$$

**Etape E21**

Il s'agit de l'étape de fin de l'algorithme. A cette étape, le système a déterminé la séquence d'impulsions optimale permettant de remplir l'objectif visé lors de l'étape E17.

Les figures 5A à 5C représentent différents diagrammes permettant de mieux comprendre le principe de l'invention.

La figure 5A montre une séquence d'impulsions à N=2 dans laquelle toutes les impulsions ont une largeur identique. Dans cette séquence, le courant résonant Ir reste identique entre le début de la séquence et la fin de la séquence, ce qui est l'un des objectifs visés par la séquence. Cependant la séquence d'impulsions n'est pas optimale car le courant résonant Ir au niveau de la transition de commutation n'est pas nul, entraînant des pertes par commutation.

Sur la figure 5B, la séquence appliquée est optimisée par rapport à la précédente car le courant résonant est nul au moment de chaque transition de commutation. Cela est permis car la largeur des impulsions de la séquence est optimisée selon l'objectif de réduction des pertes par commutation défini par la relation (4) ci-dessus.

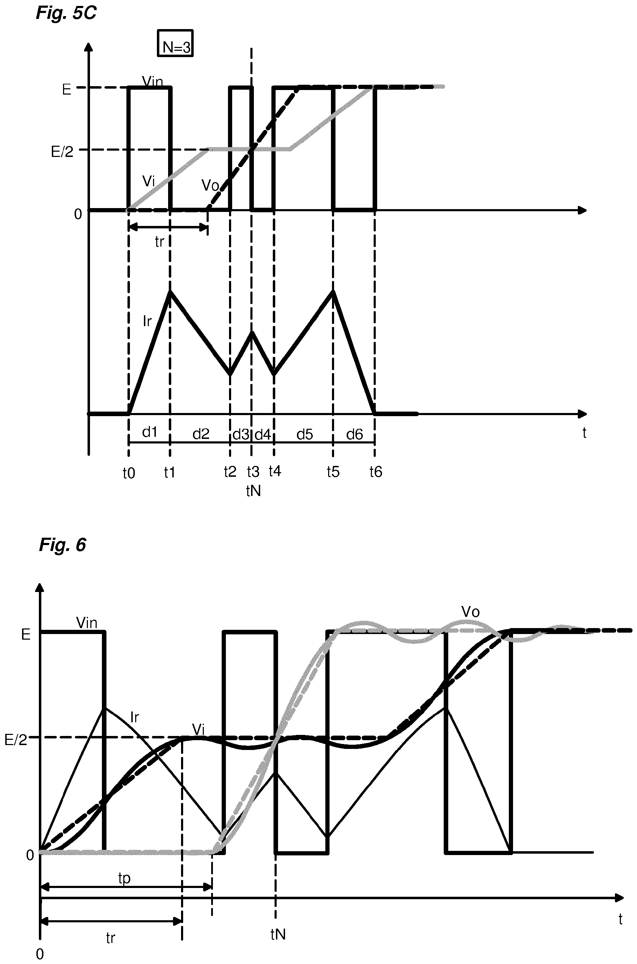

Sur la figure 5C, la séquence d'impulsions proposée permet de minimiser les surtensions aux bornes de la machine électrique lors d'une transition de commutation au niveau d'un bras de commutation. La durée de montée de la tension Vi en entrée du câble jusqu'à la valeur E/2 définit la durée $t_r$. Par ailleurs, la particularité de cette séquence est que la tension Vo (en pointillés) aux bornes de la machine M est proche de la valeur E/2 à l'instant $t_N$, définissant la symétrie de la séquence.

La figure 6 représente une simulation qui permet de montrer que le phénomène de surtensions est atténué lorsque la séquence d'impulsions qui est appliquée est optimisée. La courbe de la tension Vo et la courbe de tension Vi obtenues présentent chacune une moyenne (en pointillés) qui se rapprochent de la solution idéale.

Il ressort de ce qui précède que le procédé de commande de l'invention ainsi que le système employé pour sa mise en œuvre présentent un certain nombre d'avantages, parmi lesquels :

- Ils permettent de déterminer une séquence d'impulsions optimale par rapport à l'objectif visé, quel que soit le dimensionnement du filtre F ;

- Ils permettent de limiter au maximum les surtensions aux bornes de la machine électrique lors des commutations, même si l'onduleur employé est à deux niveaux.

**Revendications**

1. Procédé de commande d'un convertisseur configuré pour être connecté à une machine électrique par un câble (Cx) via un filtre (F) connecté à la sortie de l'onduleur (20), ledit câble (Cx) comprenant au moins deux conducteurs et présentant une impédance et ledit filtre étant de type LC et comprenant au moins une inductance (Lf) et un condensateur (Cf) pour chaque conducteur du câble, ledit convertisseur comprenant au moins deux bras de commutation comportant chacun au moins deux interrupteurs de puissance commutés pour découper une tension continue ayant une valeur E afin de fournir au moins deux niveaux de tension, la commande d'un bras de commutation permettant de générer des impulsions de tension sur la phase de sortie qui lui est connectée, une impulsion de tension pouvant être de type croissante et comporter un front de tension vertical montant avec un palier de durée non nulle à la valeur E ou de type décroissante et comporter un front de tension vertical descendant avec un palier de durée non nulle à la valeur 0V, ledit procédé étant **caractérisé en ce qu'**il consiste à déterminer au moins une séquence de plusieurs impulsions de tension formant un signal carré à appliquer sur chaque conducteur à chaque transition de commutation des deux interrupteurs de puissance d'un même bras de commutation, les deux interrupteurs étant commandés en complémentaire, pour minimiser un niveau de surtension aux bornes de la machine électrique (M), ladite séquence comprenant un nombre 2N d'impulsions successives, N étant supérieur ou égal à 1, chaque impulsion étant défini par un rang n distinct, ladite séquence étant générée en remplaçant chaque front montant et chaque front descendant des impulsions de tension générées à la période de découpage de la tension continue et de sorte que chaque impulsion de tension croissante de rang n présente une largeur d'impulsion identique à celle d'une impulsion de tension décroissante de rang égal à 2N+1-n, et **en ce qu'**il comporte les étapes suivantes :

    - Déterminer le nombre d'impulsions successives de ladite séquence,
    - Déterminer la largeur de chaque impulsion de la séquence adaptée pour minimiser le niveau de surtension aux bornes de la machine électrique (M) en respectant la relation suivante :

$$t_N = t_p + t_r/2$$

    Dans laquelle :

- $t_N$ correspond à un instant temporel de fin de l'impulsion de rang N,
- $t_p$ correspond au temps de propagation du câble,
- $t_r$ correspond au temps de montée de la tension (Vi) présente à l'entrée du câble pour atteindre 50% de ladite valeur E de la tension continue ;

caractérisé aussi **en ce qu'**il comporte une étape d'augmentation du nombre d'impulsions de la séquence tant que le niveau de surtension obtenu dépasse une valeur seuil.

2. Procédé selon la revendication 1, **caractérisé en ce qu'**il comporte une étape de détermination du niveau de surtension à partir de la relation suivante :

$$Int_{Vo} = \lim_{T \to \infty} \frac{1}{T} \int_0^T \left( Vo\big(L, C, Zc, t_p, t_1, t_2, t_3 \cdots t_{2N}\big) \right)^2 dt$$

Dans laquelle :

- $Int_{Vo}$ correspond audit niveau de surtension résultant du calcul de l'intégrale de la tension $Vo$ aux bornes de la machine électrique ;
- L correspond à la valeur de l'inductance du filtre ;
- C correspond à la capacité du condensateur du filtre ;
- Zc correspond à l'impédance caractéristique du câble.

3. Procédé selon la revendication 2, **caractérisé en ce qu'**il comporte au moins une étape de comparaison du niveau de surtension déterminé pour ladite séquence d'impulsion avec ladite valeur seuil.

4. Procédé selon l'une des revendications 1 à 3, **caractérisé en ce qu'**il comporte une étape de détermination du temps de montée de la tension (Vi) à l'entrée du câble pour atteindre 50% de ladite valeur E de la tension continue à partir de la relation suivante :

$$t_r = f(L, C, Zc, d_1, d_2 \ldots d_N)$$

Dans laquelle :

- L correspond à la valeur de l'inductance du filtre ;
- C correspond à la capacité du condensateur du filtre ;
- Zc correspond à l'impédance caractéristique du câble ;
- $d_1$, $d_2 \ldots d_N$ correspondent à la largeur de chaque impulsion de rang n de ladite séquence d'impulsions.

5. Procédé selon la revendication 2, **caractérisé en ce qu'**il comporte une étape de saisie ou d'identification des paramètres suivants :

- L correspondant à la valeur de l'inductance du filtre ;
- C correspondant à la capacité du condensateur du filtre ;
- Zc correspondant à l'impédance caractéristique du câble ;
- tp correspondant au temps de propagation du câble.

6. Système de commande d'un convertisseur configuré pour être connecté à une machine électrique par un câble (Cx) via un filtre (F) connecté à la sortie de l'onduleur (20), ledit câble (Cx) comprenant au moins deux conducteurs et présentant une impédance et ledit filtre étant de type LC et comprenant au moins une inductance (Lf) et un condensateur (Cf) pour chaque conducteur du câble, ledit convertisseur comprenant au moins deux bras de commutation comportant chacun au moins deux interrupteurs de puissance commutés pour découper une tension continue ayant une valeur E afin de fournir au moins deux niveaux de tension, la commande d'un bras de commutation permettant de générer des impulsions de tension sur la phase de sortie qui lui est connectée, une impulsion de tension pouvant être de type croissante et comporter un front de tension vertical montant avec un palier de durée non nulle à la valeur E ou de type décroissante et comporter un front de tension vertical descendant avec un palier de durée non nulle à la valeur 0V, ledit système étant **caractérisé en ce qu'**il est adapté pour déterminer au moins une séquence de plusieurs impulsions de tension formant un signal carré à appliquer sur chaque conducteur à chaque transition de commutation des deux interrupteurs de puissance d'un même bras de commutation, les deux interrupteurs étant commandés en complémentaire, pour minimiser un niveau de surtension aux bornes de la machine électrique (M), ladite séquence comprenant un nombre 2N d'impulsions successives, N étant supérieur ou égal à 1, chaque impulsion étant défini par un rang n distinct, ladite séquence étant générée en remplaçant chaque front montant et chaque front descendant des impulsions de tension générées à la période de découpage de la tension continue et de sorte que chaque impulsion de tension croissante de rang n présente une largeur d'impulsion identique à celle d'une impulsion de tension décroissante de rang égal à 2N+1-n, et **en ce qu'**il est également adapté pour :

- Déterminer le nombre d'impulsions successives de ladite séquence,
- Déterminer la largeur de chaque impulsion de la séquence adaptée pour minimiser le niveau de surtension aux bornes de la machine électrique (M) en respectant la relation suivante :

$$t_N = t_p + t_r/2$$

Dans laquelle :

- $t_N$ correspond à un instant temporel de fin de l'impulsion de rang N,
- $t_p$ correspond au temps de propagation du câble,
- $t_r$ correspond au temps de montée de la tension (Vi) présente à l'entrée du câble pour atteindre 50% de ladite valeur E de la tension continue ;

caractérisé aussi **en ce qu'**il est adapté pour augmenter le nombre d'impulsions de la séquence tant que le niveau de surtension obtenu dépasse une valeur seuil.

7. Système selon la revendication 6, **caractérisé en ce qu'**il est adapté pour déterminer un niveau de surtension à partir de la relation suivante :

$$Int_{Vo} = \lim_{T \to \infty} \frac{1}{T} \int_0^T \left( Vo\big(L, C, Zc, t_p, t_1, t_2, t_3 \cdots t_{2N}\big) \right)^2 dt$$

Dans laquelle :

- $Int_{Vo}$ correspond audit niveau de surtension résultant du calcul de l'intégrale de la tension $Vo$ aux bornes de la machine électrique ;
- L correspond à la valeur de l'inductance du filtre ;
- C correspond à la capacité du condensateur du filtre ;
- Zc correspond à l'impédance caractéristique du câble.

8. Système selon la revendication 7, **caractérisé en ce qu'**il est adapté pour comparer ledit niveau de surtension déterminé pour ladite séquence d'impulsion avec ladite valeur seuil.

9. Système selon l'une des revendications 6 à 8, **caractérisé en ce qu'**il est adapté pour déterminer le temps de montée de la tension (Vi) présente à l'entrée du câble pour atteindre 50% de ladite valeur E de la tension continue à partir de la relation suivante :

$$t_r = f(L, C, Zc, d_1, d_2 \ldots d_N)$$

Dans laquelle :

- L correspond à la valeur de l'inductance du filtre ;
- C correspond à la capacité du condensateur du filtre ;
- Zc correspond à l'impédance caractéristique du câble ;
- $d_1$, $d_2 \ldots d_N$ correspondent à la largeur de chaque impulsion de rang n de ladite séquence d'impulsions.

**10.** Système selon la revendication 7, **caractérisé en ce qu'**il comporte un module de saisie ou d'identification des paramètres suivants :

- L correspondant à la valeur de l'inductance du filtre ;
- C correspondant à la capacité du condensateur du filtre ;
- Zc correspondant à l'impédance caractéristique du câble ;
- tp correspondant au temps de propagation du câble.

**Patentansprüche**

**1.** Verfahren zur Steuerung eines Wandlers, der dazu ausgelegt ist, an eine elektrische Maschine mit einem Kabel (Cx) über einen Filter (F) angeschlossen zu werden, der an den Ausgang des Wechselrichters (20) angeschlossen ist, wobei das Kabel (Cx) mindestens zwei Leiter umfasst und eine Impedanz aufweist und der Filter vom Typ LC ist und mindestens eine Induktivität (Lf) und einen Kondensator (Cf) für jeden Leiter des Kabels umfasst, wobei der Wandler mindestens zwei Schaltarme umfasst, die jeweils mindestens zwei Leistungsschalter beinhalten, die umgeschaltet werden, um eine Gleichspannung mit einem Wert E zu zerhacken, damit mindestens zwei Spannungspegel bereitgestellt werden, wobei das Steuern eines Schaltarms es ermöglicht, Spannungsimpulse an der an ihn angeschlossenen Ausgangsphase zu erzeugen, wobei ein Spannungsimpuls vom zunehmenden Typ sein kann und eine vertikale steigende Spannungsflanke mit einem Plateau mit einer Dauer ungleich null beim Wert E beinhalten kann oder vom abnehmenden Typ sein kann und eine vertikale fallende Spannungsflanke mit einem Plateau mit einer Dauer ungleich null beim Wert 0V beinhalten kann, wobei das Verfahren **dadurch gekennzeichnet ist, dass** es darin besteht, mindestens eine Folge aus mehreren ein Rechtecksignal bildenden Spannungsimpulsen zu bestimmen, die an jeden Leiter bei jedem Schaltübergang der beiden Leistungsschalter desselben Schaltarms anzulegen ist, wobei die beiden Schalter komplementär gesteuert werden, um einen Überspannungspegel an den Klemmen der elektrischen Maschine (M) zu minimieren, wobei die Folge eine Anzahl 2N aufeinander folgender Impulse umfasst, wobei N größer oder gleich 1 ist, wobei jeder Impuls durch einen unterschiedlichen Rang n definiert ist, wobei die Folge erzeugt wird, indem jede steigende Flanke und jede fallende Flanke der mit der Zerhackungsperiode der Gleichspannung erzeugten Spannungsimpulse ersetzt wird, und so, dass jeder zunehmende Spannungsimpuls mit dem Rang n eine Impulsbreite aufweist, die identisch mit der eines abnehmenden Spannungsimpulses mit dem Rang gleich 2N+1-n ist, und dadurch, dass es die folgenden Schritte beinhaltet:

- Bestimmen der Anzahl aufeinander folgender Impulse der Folge,
- Bestimmen der Breite jedes Impulses der Folge, die angepasst ist, um den Überspannungspegel an den Klemmen der elektrischen Maschine (M) zu minimieren, unter Beachtung der folgenden Gleichung:

$$t_N = t_p + t_r/2$$

in der:

- $t_N$ einem Endezeitpunkt des Impulses mit dem Rang N entspricht,
- $t_p$ der Laufzeit des Kabels entspricht,
- $t_r$ der Anstiegszeit der Spannung (Vi) entspricht, die am Eingang des Kabels anliegt, um 50 % des Werts E der Gleichspannung zu erreichen;

auch **dadurch gekennzeichnet, dass** es einen Schritt der Erhöhung der Impulsanzahl der Folge beinhaltet, solange der erhaltene Überspannungspegel einen Schwellenwert überschreitet.

**2.** Verfahren nach Anspruch 1, **dadurch gekennzeichnet, dass** es einen Schritt der Bestimmung des Überspannungspegels anhand der folgenden Gleichung beinhaltet:

$$Int_{V0} = \lim_{T \to \infty} \frac{1}{T} \int_0^T (V_0(L, C, Zc, t_p, t_1, t_2, t_3 \dots t_{2N}))^2 \, dt$$

in der:

- $Int_{Vo}$ dem Überspannungspegel entspricht, der aus der Berechnung des Integrals der Spannung $V_0$ an den Klemmen der elektrischen Maschine resultiert;
- L dem Wert der Induktivität des Filters entspricht;
- C der Kapazität des Kondensators des Filters entspricht;
- Zc dem Wellenwiderstand des Kabels entspricht.

3. Verfahren nach Anspruch 2, **dadurch gekennzeichnet, dass** es mindestens einen Schritt des Vergleichens des für die Impulsfolge bestimmten Überspannungspegels mit dem Schwellenwert beinhaltet.

4. Verfahren nach einem der Ansprüche 1 bis 3, **dadurch gekennzeichnet, dass** es einen Schritt der Bestimmung der Anstiegszeit der Spannung (Vi) am Eingang des Kabels, um 50 % des Werts E der Gleichspannung zu erhalten, anhand der folgenden Gleichung beinhaltet:

$$t_r = f(L, C; Zc, d_1, d_2 \ldots d_N)$$

in der:

- L dem Wert der Induktivität des Filters entspricht;
- C der Kapazität des Kondensators des Filters entspricht;
- Zc dem Wellenwiderstand des Kabels entspricht;
- $d_1, d_2 \ldots d_N$ der Breite jedes Impulses mit dem Rang n der Impulsfolge entsprechen.

5. Verfahren nach Anspruch 2, **dadurch gekennzeichnet, dass** es einen Schritt der Erfassung oder Identifizierung der folgenden Parameter beinhaltet:

- L, entsprechend dem Wert der Induktivität des Filters;
- C, entsprechend der Kapazität des Kondensators des Filters;
- Zc, entsprechend dem Wellenwiderstand des Kabels;
- tp, entsprechend der Laufzeit des Kabels.

6. System zur Steuerung eines Wandlers, der dazu ausgelegt ist, an eine elektrische Maschine mit einem Kabel (Cx) über einen Filter (F) angeschlossen zu werden, der an den Ausgang des Wechselrichters (20) angeschlossen ist, wobei das Kabel (Cx) mindestens zwei Leiter umfasst und eine Impedanz aufweist und der Filter vom Typ LC ist und mindestens eine Induktivität (Lf) und einen Kondensator (Cf) für jeden Leiter des Kabels umfasst, wobei der Wandler mindestens zwei Schaltarme umfasst, die jeweils mindestens zwei Leistungsschalter beinhalten, die umgeschaltet werden, um eine Gleichspannung mit einem Wert E zu zerhacken, damit mindestens zwei Spannungspegel bereitgestellt werden, wobei das Steuern eines Schaltarms es ermöglicht, Spannungsimpulse an der an ihn angeschlossenen Ausgangsphase zu erzeugen, wobei ein Spannungsimpuls vom zunehmenden Typ sein kann und eine vertikale steigende Spannungsflanke mit einem Plateau mit einer Dauer ungleich null beim Wert E beinhalten kann oder vom abnehmenden Typ sein kann und eine vertikale fallende Spannungsflanke mit einem Plateau mit einer Dauer ungleich null beim Wert 0V beinhalten kann, wobei das System **dadurch gekennzeichnet ist, dass** es dazu geeignet ist, mindestens eine Folge aus mehreren ein Rechtecksignal bildenden Spannungsimpulsen zu bestimmen, die an jeden Leiter bei jedem Schaltübergang der beiden Leistungsschalter desselben Schaltarms anzulegen ist, wobei die beiden Schalter komplementär gesteuert werden, um einen Überspannungspegel an den Klemmen der elektrischen Maschine (M) zu minimieren, wobei die Folge eine Anzahl 2N aufeinander folgender Impulse umfasst, wobei N größer oder gleich 1 ist, wobei jeder Impuls durch einen unterschiedlichen Rang n definiert ist, wobei die Folge erzeugt wird, indem jede steigende Flanke und jede fallende Flanke der mit der Zerhackungsperiode der Gleichspannung erzeugten Spannungsimpulse ersetzt wird, und so, dass jeder zunehmende Spannungsimpuls mit dem Rang n eine Impulsbreite aufweist, die identisch mit der eines abnehmenden Spannungsimpulses mit dem Rang gleich 2N+1-n ist, und dadurch, dass es auch zu Folgendem geeignet ist:

- Bestimmen der Anzahl aufeinander folgender Impulse der Folge,
- Bestimmen der Breite jedes Impulses der Folge, die angepasst ist, um den Überspannungspegel an den Klemmen der elektrischen Maschine (M) zu minimieren, unter Beachtung der folgenden Gleichung:

$$t_N = t_p + t_r/2$$

in der:

- $t_N$ einem Endezeitpunkt des Impulses mit dem Rang N entspricht,
- $t_p$ der Laufzeit des Kabels entspricht,
- $t_r$ der Anstiegszeit der Spannung (Vi) entspricht, die am Eingang des Kabels anliegt, um 50 % des Werts E der Gleichspannung zu erreichen;

auch **dadurch gekennzeichnet, dass** es geeignet ist, die Impulsanzahl der Folge zu erhöhen, solange der erhaltene Überspannungspegel einen Schwellenwert überschreitet.

7. System nach Anspruch 6, **dadurch gekennzeichnet, dass** es geeignet ist, einen Überspannungspegel anhand der folgenden Gleichung zu bestimmen:

$$Int_{V0} = \lim_{T \to \infty} \frac{1}{T} \int_0^T (V_0(L, C, Zc, t_p, t_1, t_2, t_3 \dots t_{2N}))^2 \, dt$$

in der:

- $Int_{V0}$ dem Überspannungspegel entspricht, der aus der Berechnung des Integrals der Spannung $V_0$ an den Klemmen der elektrischen Maschine resultiert;
- L dem Wert der Induktivität des Filters entspricht;
- C der Kapazität des Kondensators des Filters entspricht;
- Zc dem Wellenwiderstand des Kabels entspricht.

8. System nach Anspruch 7, **dadurch gekennzeichnet, dass** es dazu geeignet ist, den für die Impulsfolge bestimmten Überspannungspegel mit dem Schwellenwert zu vergleichen.

9. System nach einem der Ansprüche 6 bis 8, **dadurch gekennzeichnet, dass** es dazu geeignet ist, die Anstiegszeit der Spannung (Vi), die am Eingang des Kabels anliegt, um 50 % des Werts E der Gleichspannung zu erreichen, anhand der folgenden Gleichung zu bestimmen:

$$t_r = f(L, C; Zc, d_1, d_2 \dots d_N)$$

in der:

- L dem Wert der Induktivität des Filters entspricht;
- C der Kapazität des Kondensators des Filters entspricht;
- Zc dem Wellenwiderstand des Kabels entspricht;
- $d_1, d_2 \dots d_N$ der Breite jedes Impulses mit dem Rang n der Impulsfolge entsprechen.

10. System nach Anspruch 7, **dadurch gekennzeichnet, dass** es ein Modul zur Erfassung oder Identifizierung der folgenden Parameter beinhaltet:

- L, entsprechend dem Wert der Induktivität des Filters;
- C, entsprechend der Kapazität des Kondensators des Filters;
- Zc, entsprechend dem Wellenwiderstand des Kabels;
- tp, entsprechend der Laufzeit des Kabels.

**Claims**

1. Method for controlling a converter configured so as to be connected to an electric machine by a cable (Cx) via a filter (F) connected to the output of the inverter (20), said cable (Cx) comprising at least two conductors and exhibiting an impedance and said filter being an LC filter and comprising at least one inductor (Lf) and one capacitor (Cf) for each conductor of the cable, said converter comprising at least two switching arms each comprising at least two power switches that are switched so as to chop a DC voltage having a value E in order to deliver at least two voltage levels, the controlling of a switching arm making it possible to generate voltage pulses on the output phase that is connected thereto, a voltage pulse potentially being an increasing voltage pulse and including a vertical voltage edge rising with an increment of non-zero duration to the value E or a decreasing voltage pulse and including a vertical voltage edge falling with an increment of non-zero duration to the value 0 V, said method being **characterized in that** it consists in determining at least one sequence of a plurality of voltage pulses forming a square wave signal to be applied to each conductor on each switching transition of the two power switches of one and the same switching arm, the two switches being controlled complementarily, so as to minimize an overvoltage level across the terminals of the electric machine (M), said sequence comprising a number 2N of successive pulses, N being greater than or equal to 1, each pulse being defined by a distinct rank n, said sequence being generated by replacing each rising edge and each falling edge of the voltage pulses generated at the chopping period of the DC voltage and such that each increasing voltage pulse of rank n exhibits a pulse width that is identical to that of a decreasing voltage pulse of rank equal to 2N+1-n, and **in that** it includes the following steps:

- determining the number of successive pulses of said sequence;
- determining the width of each pulse of the sequence made suitable for minimizing the overvoltage level across the terminals of the electric machine (M) while satisfying the following relationship:

$$t_N = t_p + t_r/2$$

where:

- $t_N$ corresponds to an instant in time of the end of the pulse of rank N;
- $t_p$ corresponds to the propagation time of the cable;
- $t_r$ corresponds to the rise time for the voltage (Vi) present at the input of the cable to reach 50% of said value E of the DC voltage;

also **characterized in that** it includes a step of increasing the number of pulses in the sequence for as long as the obtained overvoltage level exceeds a threshold value.

2. Method according to Claim 1, **characterized in that** it includes a step of determining the overvoltage level on the basis of the following relationship:

$$Int_{Vo} = \lim_{T \to \infty} \frac{1}{T} \int_0^T \left( Vo(L, C, Zc, t_p, t_1, t_2, t_3 \cdots t_{2N}) \right)^2 dt$$

where:

- $Int_{Vo}$ corresponds to said overvoltage level resulting from calculating the integral of the voltage *Vo* across the terminals of the electric machine;
- *L* corresponds to the inductance of the inductor of the filter;
- *C* corresponds to the capacitance of the capacitor of the filter;
- *Zc* corresponds to the characteristic impedance of the cable.

3. Method according to Claim 2, **characterized in that** it includes at least one step of comparing the overvoltage level determined for said pulse sequence with said threshold value.

4. Method according to one of Claims 1 to 3, **characterized in that** it includes a step of determining the rise time for the voltage (Vi) at the input of the cable to reach 50% of said value E of the DC voltage on the basis of the following relationship:

$$t_r = f(L, C, Zc, d_1, d_2 \ldots d_N)$$

where:

- *L* corresponds to the inductance of the inductor of the filter;

- *C* corresponds to the capacitance of the capacitor of the filter;
- *Zc* corresponds to the characteristic impedance of the cable;
- $d_1,d_2...d_N$ correspond to the width of each pulse of rank n of said sequence of pulses.

5. Method according to Claim 2, **characterized in that** it includes a step of entering or of identifying the following parameters:

   - *L,* corresponding to the inductance of the inductor of the filter;
   - *C,* corresponding to the capacitance of the capacitor of the filter;
   - *Zc,* corresponding to the characteristic impedance of the cable;
   - *tp,* corresponding to the propagation time of the cable.

6. System for controlling a converter configured so as to be connected to an electric machine by a cable (Cx) via a filter (F) connected to the output of the inverter (20), said cable (Cx) comprising at least two conductors and exhibiting an impedance and said filter being an LC filter and comprising at least one inductor (Lf) and one capacitor (Cf) for each conductor of the cable, said converter comprising at least two switching arms each comprising at least two power switches that are switched so as to chop a DC voltage having a value E in order to deliver at least two voltage levels, the controlling of a switching arm making it possible to generate voltage pulses on the output phase that is connected thereto, a voltage pulse potentially being an increasing voltage pulse and including a vertical voltage edge rising with an increment of non-zero duration to the value E or a decreasing voltage pulse and including a vertical voltage edge falling with an increment of non-zero duration to the value 0 V, said system being **characterized in that** it is suitable for determining at least one sequence of a plurality of voltage pulses forming a square wave signal to be applied to each conductor on each switching transition of the two power switches of one and the same switching arm, the two switches being controlled complementarily, so as to minimize an overvoltage level across the terminals of the electric machine (M), said sequence comprising a number 2N of successive pulses, N being greater than or equal to 1, each pulse being defined by a distinct rank n, said sequence being generated by replacing each rising edge and each falling edge of the voltage pulses generated at the chopping period of the DC voltage and such that each increasing voltage pulse of rank n exhibits a pulse width that is identical to that of a decreasing voltage pulse of rank equal to 2N+1-n, and **in that** it is also suitable for:

   - determining the number of successive pulses of said sequence;
   - determining the width of each pulse of the sequence made suitable for minimizing the overvoltage level across the terminals of the electric machine (M) while satisfying the following relationship:

$$t_N = t_p + t_r/2$$

   where:

   - $t_N$ corresponds to an instant in time of the end of the pulse of rank N;
   - $t_p$ corresponds to the propagation time of the cable;
   - $t_r$ corresponds to the rise time for the voltage (Vi) present at the input of the cable to reach 50% of said value E of the DC voltage,

also **characterized in that** it is suitable for increasing the number of pulses in the sequence for as long as the obtained overvoltage level exceeds a threshold value.

7. System according to Claim 6, **characterized in that** it is suitable for determining an overvoltage level on the basis of the following relationship:

$$Int_{Vo} = \lim_{T \to \infty} \frac{1}{T} \int_0^T \left( Vo(L, C, Zc, t_p, t_1, t_2, t_3 \cdots t_{2N}) \right)^2 dt$$

   where:

   - $Int_{Vo}$ corresponds to said overvoltage level resulting from calculating the integral of the voltage Vo across the terminals of the electric machine;

- L corresponds to the inductance of the inductor of the filter;
- C corresponds to the capacitance of the capacitor of the filter;
- Zc corresponds to the characteristic impedance of the cable.

8. System according to Claim 7, **characterized in that** it is suitable for comparing said overvoltage level determined for said pulse sequence with said threshold value.

9. System according to one of Claims 6 to 8, **characterized in that** it is suitable for determining the rise time for the voltage (Vi) present at the input of the cable to reach 50% of said value E of the DC voltage on the basis of the following relationship:

$$t_r = f(L, C, Zc, d_1, d_2 \ldots d_N)$$

where:

- $L$ corresponds to the inductance of the inductor of the filter;
- $C$ corresponds to the capacitance of the capacitor of the filter;
- $Zc$ corresponds to the characteristic impedance of the cable;
- $d_1, d_2 \ldots d_N$ correspond to the width of each pulse of rank n of said sequence of pulses.

10. System according to Claim 7, **characterized in that** it includes a module for entering or for identifying the following parameters:

- $L$, corresponding to the inductance of the inductor of the filter;
- $C$, corresponding to the capacitance of the capacitor of the filter;
- $Zc$, corresponding to the characteristic impedance of the cable;
- $tp$, corresponding to the propagation time of the cable.

**Fig. 1**

200

Cb1

T1W   T1V   T1U

U
V
W

F

Lf

Cb2

T2W   T2V   T2U

Cf

Cx   Zc
     tp
     Lg

M

100

**Fig. 2A**

Cb1

100   T1U

Lf   IL

Vin

Ir

Vi

Cf

Cx   Zc
     tp
     Lg

Vo

Cb2   T2U

**Fig. 2B**

IL   L

C

C_cx

C_cx   C_cx

L   C C   L

Fig. 3

T_mli

Vin

E

0V

t

E

0V

t

E

0V

t

Fig. 4

Vin

Ir

t0    t1      t2  t3 t4       tN tn-1 tn tn+1              t2N

Fig. 5A

Fig. 5B

## Fig. 5C

## Fig. 6

**Fig. 7**

## RÉFÉRENCES CITÉES DANS LA DESCRIPTION

**Littérature non-brevet citée dans la description**

- Control of an inverter output active du/dt filtering method. **JUHAMATII KORHONEN ; JUHA-PEKKA STRÖM ; JUHO TYSER ; PERTTI SILVENTOINEN ; HANNU SARÉN ; KIMMO RAU-MA.** Proceedings of the 35th. Annual Conférence of the IEEE Industrial Electronics Society. IECON, 2009